**Europäisches Patentamt**

**European Patent Office**

**Office européen des brevets**

(19)

(11) Veröffentlichungsnummer: **0 218 832 B1**

## (12) EUROPÄISCHE PATENTSCHRIFT

(45) Veröffentlichungstag der Patentschrift:
22.11.90

(51) Int. Cl.⁵: **H05K 3/30**

(21) Anmeldenummer: 86110874.4

(22) Anmeldetag: 06.08.86

(54) Bauelement für die Oberflächenmontage und Verfahren zur Befestigung eines Bauelements für die Oberflächenmontage.

(30) Priorität: 30.09.85 DE 3534872

(43) Veröffentlichungstag der Anmeldung:
22.04.87 Patentblatt 87/17

(45) Bekanntmachung des Hinweises auf die Patenterteilung:
22.11.90 Patentblatt 90/47

(84) Benannte Vertragsstaaten:
DE FR GB

(56) Entgegenhaltungen:
WO-A-85/01634
DE-A- 3 231 277
FR-A- 2 502 387
GB-A- 1 335 159

(73) Patentinhaber: Siemens Aktiengesellschaft,
Wittelsbacherplatz 2, D-8000 München 2(DE)

(72) Erfinder: Hargasser, Hans, Dipl.-Ing.(FH),
Salzmannstrasse 46, D-8000 München 83(DE)
Erfinder: Dathe, Joachim, Dipl.-Phys.,
Schleissheimerstrasse 276, D-8000 München 40(DE)

**Beschreibung**

Die Erfindung betrifft ein Bauelement für die Oberflächenmontage

Seit mehreren Jahren werden Bauelemente für die Oberflächenmontage, bekannt unter der Bezeichnung SMD (Surface mounted Device), zur Hybridisierung von Schichtschaltungen verwendet. Der Masseneinsatz von SMD-Bauelementen bringt zusammen mit dem Übergang von Handbestückung auf automatische Bestückung einen wesentlichen Anstieg der Rentabilität. Nachdem nun ein umfangreiches Programm an Bauteilen und Bestückungsautomaten vorhanden ist, gehen immer mehr Anwender dazu über, diese Aufbautechnologie auch für Leiterplatten einzuführen.

Bauelemente für die Oberflächenmontage werden üblicherweise aus einem Transportgurt, d.h. aus einer Plastikkavität genommen und in positionierter Weise auf die Oberfläche eines anderen Körpers, beispielsweise einer Leiterplatte, geklebt. Anschließend wird der andere Körper gewendet und zur Lötung der Bauelemente-Anschlüsse durch ein Zinnbad bzw. in ein Lötbad getaucht.

Von besonderer Bedeutung dabei ist die schnelle und sichere Befestigung der Bauelemente auf dem anderen Körper vom Zeitpunkt der Positionierung der Bauelemente an bis zum Ende des Lötvorganges, d.h. bis zum Erstarren der Lötstellen.

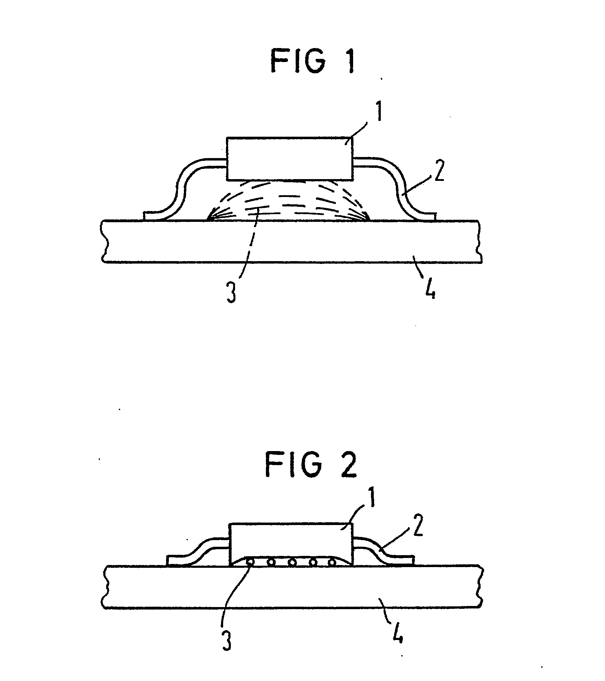

Fig. 1 zeigt, wie das dabei auftretende technische Problem bisher gelöst worden ist. Nach dem Stand der Technik müssen zur sicheren Klebung eines Bauelements für die Oberflächenmontage folgende Bedingungen eingehalten werden:

1. Die Klebemasse 3 muß unter dem Gehäuse 1 des SMD-Bauelements positioniert werden.

2. Die nach dem Stand der Technik aufgespritze Menge des Klebers 3 muß nach dem Stand der Technik so dosiert sein, daß einerseits das Gehäuse 1 des SMD-Bauelements und die Oberfläche eines anderen Körpers 4, auf dem das SMD-Bauelement befestigt werden soll, ausreichend bedeckt werden, um die notwendige Haftfestigkeit des SMD-Bauelements zu erreichen, und daß andererseits die Klebemasse 3 nicht die Lötflächen der Bauelement-Anschlüsse bedeckt.

Der Abstand des Gehäuses 1 des SMD-Bauelements von der Oberfläche des anderen Körpers 4, auf dem das SMD-Bauelement befestigt werden soll, darf nicht infolge der Fertigungstoleranzen, die bei der Biegung der Anschlußbeinchen 2 des SMD-Bauelements unvermeidlich auftreten, zu groß werden. Beispielsweise beträgt der Abstand des Gehäuses 1 des SMD-Bauelements von der Oberfläche des anderen Körpers 4, auf dem das SMD-Bauelement befestigt werden soll, 0,05 + 0,05 mm.

Das gesamte Verfahren zur Befestigung eines SMD-Bauelements nach dem Stand der Technik ist insgesamt sehr aufwendig, damit auch bei einem Bauelement und bei einem Verfahren nach dem Stand der Technik eine sichere Klebung eines SMD-Bauelements erreicht werden kann. Die Positinierung der Klebemasse 3 unter dem Gehäuse 1 des SMD-Bauelements nach dem Stand der Technik erfordert einen relativ großen Aufwand. Nach dem Stand der Technik muß die Klebemasse 3 aufgespritzt werden und muß dabei außerdem noch in relativ engen Toleranzen dosiert werden. Die bei der Biegung der Anschlußbeinchen des SMD-Bauelements unvermeidlichen Fertigungstoleranzen beeinflussen den Abstand des Gehäuses 1 von der Oberfläche des anderen Körpers 4, auf dem das SMD-Bauelement befestigt werden soll. Bei einem Bauelement und bei einem Verfahren nach dem Stand der Technik kann der Abstand des Gehäuses 1 des SMD-Bauelements von der Oberfläche des anderen Körpers 4, auf dem das SMD-Bauelement fixiert werden soll, nur bis auf diese Fertigungstoleranzen der Anschlußbeinchen des SMD-Bauelements genau angegeben werden. Aufgrund dieser Toleranz beim Abstand des Gehäuses 1 von der Oberfläche des anderen Körper 4 ist auch die Dosierung der Klebemasse 3 mit einer Toleranz behaftet. Diese Dosierung der Klebemasse 3 hängt nämlich vom Abstand des Gehäuses 1 von der Oberfläche des anderen Körper 4, auf dem das SMD-Bauelement befestigt werden soll, ab. Wenn nun infolge von Fertigungstoleranzen bei der Biegung der Anschlußbeinchen des SMD-Bauelements der Abstand des Gehäuses 1 von der Oberfläche des anderen Körpers 4, auf dem das SMD-Bauelement fixiert werden soll, besonders groß ausfällt, kann es sein, daß die Dosierung der Klebemasse 3 nicht mehr ausreicht, um das Gehäuse 1 und die Oberfläche des anderen Körpers 4 ausreichend zu bedecken und um damit die notwendige Haftfestigkeit des SMD-Bauelements auf dem anderen Körper 4 zu gewährleisten. Wird andererseits der Abstand des Gehäuses 1 von der Oberfläche des anderen Körpers 4 von Anfang an sehr klein dimensioniert, so kann es vorkommen, daß bei einer vorgegebenen Dosiermenge der Klebemasse 3 bei manchen SMD-Bauelementen, bei denen die Biegung der Anschlußbeinchen 2 bei der Fertigung so ausgefallen ist, daß der Abstand des Gehäuses 1 von der Oberfläche des anderen Körpers 4 nicht vergrößert worden ist, die Lötflächen dieser Anschlußbeinchen von Klebemasse 3 bedeckt werden und daß damit einwandfreie Lötstellen nicht mehr möglich sind.

Aus DE-A 3 231 277 ist ein Bauelement für die Oberflächenmontage bekannt mit einer Oberfläche, die mittels eines Klebers auf einer Oberfläche eines anderen Körpers fixiert werden soll. Die zu fixierende Oberfläche des Bauelements weist dabei zur Verbesserung der Haftfestigkeit Gräben an der Unterseite eines Substrats auf.

Der vorliegenden Erfindung liegt die Aufgabe zugrunde, ein verbessertes Bauelement für die Oberflächenmontage und ein verbessertes Verfahren zur Befestigung eines Bauelements für die Oberflächenmontage anzugeben.

Diese Aufgabe wird erfindungsgemäß durch ein Bauelement nach dem Patentanspruch 1 bzw. durch ein Verfahren nach dem Patentanspruch 6 gelöst.

Die Erfindung ermöglicht eine einfache Herstellung der Bauelemente-Umhüllung und eine größere Toleranz bei der Biegung der Anschlußbeinchen bei einem Bauelement für die Oberflächenmontage.

Die Erfindung ermöglicht, daß die Unterseite des Gehäuses immer eben auf der Oberfläche des anderen Körpers aufliegen kann und somit immer einen exakt definierten Abstand zu dieser anderen Oberfläche aufweist. Daher ermöglicht es die Erfindung, daß die Anschlußbeinchen mit einer grösseren Toleranz gebogen werden können.

Zur Befestigung des Gehäuses des SMD-Bauelements mit beliebigen Abmessungen auf der Oberfläche eines anderen Körpers und mit einer beliebigen Zahl von Anschlußbeinchen wird nach der Erfindung zur Verbesserung der Haftfestigkeit die zu fixierende Oberfläche des Gehäuses des SMD-Bauelements so strukturiert, daß das Gehäuse des SMD-Bauelements einerseits auf der Oberfläche des anderen Körpers satt aufliegen kann und daß andererseits noch eine ausreichende Menge des Klebestoffes zwischen dem Gehäuse des SMD-Bauelements und der Oberfläche des anderen Körpers verbleibt. Diese Stukturierung der zu fixierenden Oberfläche des SMD-Bauelements erfolgt durch Bildung einer Kavität, insbesondere einer flachen Kavität. Die Bildung dieser Struktur auf der zu fixierenden Oberfläche eines SMD-Bauelements hat den Vorteil, daß bei der Herstellung des Gehäuses des SMD-Bauelements die Entformbarkeit dieses Gehäuses nicht erschwert wird. Dieser Vorteil spielt eine besondere Rolle dann, wenn das Gehäuse des SMD-Bauelements aus Plastik, aus Keramik oder aus einem sonstigen Material besteht, das in einer Guß- oder Spritzform seine Gestalt erhält und das schließlich dieser Form entnommen werden muß.

Besonders vorteilhaft ist die Anwendung der Erfindung dann, wenn die Struktur auf der zu fixierenden Oberfläche des SMD-Bauelements so erzeugt wird, daß überflüssiger Klebstoff nicht an solchen Stellen des SMD-Bauelements ausgepreßt wird, an denen sich elektrische Anschlüsse des SMD-Bauelements befinden, und wenn diejenige Stelle auf der Oberfläche des anderen Körpers, auf der das SMD-Bauelement positioniert wird, so angeordnet wird, daß überflüssiger Klebstoff an solchen Stellen ausgepreßt wird, die auch bezüglich der Oberfläche des anderen Körpers keine für die Funktion des anderen Körpers nachteilhaften Auswirkungen haben.

Als anderer Körper kommt insbesondere eine Leiterplatte in Frage, auf der ein SMD-Bauelement befestigt wird.

Die Erfindung ermöglicht es in vorteilhafter Weise, schon vor der Befestigung des SMD-Bauelements auf der Oberfläche des anderen Körpers die zu fixierende Oberfläche des SMD-Bauelements mit einem Klebstoff zu versehen. Als Klebstoff kann ein Mittel verwendet werden, das beispielsweise unter geringem Auflagedruck und/oder bei erhöhter Temperatur und/oder bei Anwendung eines Lösungsmittels eine festhaftende Verbindung zwischen dem Gehäuse des SMD-Bauelements und der Oberfläche eines anderen Körpers, auf dem das SMD-Bauelement fixiert werden soll, herstellt. Vorteilhafterweise kann dabei ein Klebstoff oder eine Klebefolie bereits vom Bauelementehersteller auf die zu fixierende Oberfläche des SMD-Bauelements aufgebracht werden.

Vorteilhafterweise kann Klebstoff bereits vor einer Gurtung des SMD-Bauelements auf die zu fixierende Oberfläche des Bauelements aufgebracht werden.

Die Erfindung ermöglicht es, den Klebstoff flächenförmig auf der Oberfläche eines anderen Körpers, auf dem das SMD-Bauelement fixiert werden soll, aufzutragen. Ein solcher Klebstoff kann beispielsweise durch Aufsprühen mit Hilfe einer oder mehrerer Masken und/oder mittels eines Druckverfahrens und/oder in Form von Klebefolien auf die Oberfläche des anderen Körpers aufgebracht werden. Das Aufbringen des Klebstoffes kann dabei unmittelbar vor der Bauelemente-Montage auf die Oberfläche des anderen Körpers oder schon bei der Herstellung des anderen Körpers erfolgen. Der Klebstoff auf der Oberfläche des anderen Körpers, auf dem das SMD-Bauelement fixiert werden soll, kann beispielsweise durch Auflagedruck und/oder durch Temperatur und/oder durch Lösungsmittel in der Klebewirkung aktiviert werden.

Die Erfindung kann bei allen SMD-Bauelementen verwendet werden. Besonders vorteilhaft ist die Erfindung bei SOT-Bauelementen, beispielsweise bei den Bauformen SOT- 23 und SOT- 143.

Ausführungsbeispiele der Erfindung sind in der Zeichnung dargestellt und werden im folgenden näher erläutert.

Fig. 1 zeigt ein Bauelement für die Oberflächenmontage nach dem Stand der Technik.
Fig. 2 zeigt ein Bauelement für die Oberflächenmontage nach der Erfindung.

Die Fig. 2 zeigt ein Bauelement für die Oberflächenmontage mit einem Gehäuse 1 und mit Anschlußbeinchen 2, das mittels einer Klebemasse 3 auf einer Leiterplatte 4 befestigt ist. Diejenige Seite des Gehäuses 1 des SMD-Bauelements, mit der das SMD-Bauelement auf der Leiterplatte 4 befestigt ist, weist dabei eine besondere Struktur auf. Das Gehäuse 1 von Figur 2 weist eine flache Kavität auf, die ermöglicht, daß das Gehäuse 1 in Figur 2 einerseits satt aufliegen kann und daß andererseits noch eine ausreichende Menge des Klebstoffes zwischen Gehäuse 1 und Leiterplatte 4 verbleibt und daß überflüssiger Klebstoff an solchen Stellen ausgepreßt wird, wo keine Gefahr besteht, daß ein Anschlußbeinchen 2 oder eine Lötstelle auf der Leiterplatte 4 mit Klebmasse bedeckt wird.

Die Oberflächenmontagetechnik ermöglicht günstige Kosten. Dieser Vorteil wird durch die Erfindung verstärkt. Die Erfindung ermöglicht eine stärkere Unabhängigkeit bei der Befestigung eines SMD-Bauelements auf der Oberfläche eines anderen Körpers von Fertigungstoleranzen bei der Biegung von Anschlußbeinchen.

Die Erfindung ermöglicht eine größere Flexibilität bei der Anwendung von SMD-Bauelementen. Die Erfindung ermöglicht das Aufbringen von Klebmasse auf die zu fixierende Seite des SMD-Bauelements und/oder auf die Oberfläche des anderen Körpers, auf die das SMD-Bauelement fixiert werden soll, bereits vor der Bauelemente-Montage. Auf Toleranzen bei der Dosierung der Klebmasse muß wesentlich weniger Rücksicht genommen werden als beim Stand der Technik. Dies ermöglicht Vorteile auch bei den Abmessungen des SMD-Bauelements.

Vorteilhafterweise werden SMD-Bauelemente in Gurtbändern geliefert. Bestückungsautomaten, denen SMD-Bauelemente in Gurtbändern zugeführt werden, arbeiten besinders kostengünstig.

Die Erfindung ermöglicht eine flexiblere, zuverlässigere, raschere und kostengünstigere Oberflächenmontage als dies nach dem Stand der Technik möglich war.

Die Erfindung ist anwendbar für Hybridschaltungen, für Sichtschaltungsaufbauten, für Leiterplatten usw. Als Kleber sind auch Mehrkomponetenkleber möglich. Die Kleberkomponenten können dabei auf die zu fixierende Seite des SMD-Bauelements und auf die Oberfläche des anderen Körpers, auf der das Bauelement befestigt werden soll, auch in Form von Klebefolien, verteilt werden.

Beim Aufbringen von SMD-Bauelementen auf ein Substrat, beispielsweise auf eine Platine, können diese SMD-Bauelemente wieder herunterfallen, wenn der Kleber, der auf dem Substrat aufgebracht werden muß, schon vor relativ langer Zeit auf das Substrat aufgebracht worden war und daher schon leicht ausgetrocknet bzw. ausgehärtet ist und daher nicht mehr viel Klebekraft besitzt. Wenn das SMD-Bauelement jedoch eine Kavität 3 besitzt, ist ein Kleber oder eine Kleberkomponente zeitgerecht ( in good time) so anbringbar, daß der Kleber insgesamt zum Zeitpunkt des Aufbringens des SMD-Baulements · auf das Substrat eine ausreichende Klebekraft entfaltet, wobei der Kleber bzw. die Kleberkomponente zugleich auch räumlich genau auf denjenigen Stellen lokal aufgebracht werden kann, an denen Klebekraft entfaltet werden muß zur zuverlässigen Befestigung des SMD-Bauelementsm ohne daß der aufgebrachte Kleber bzw. die aufgebrachte Kleberkomponente verrutscht oder verfließt oder vertropft und somit sich schließlich an Stellen befinden würde, wo Klebemasse unerwünscht ist.

Die Kavität 3 ist eine gut geeignete Form, um zuverlässig eine ausreichende Menge Kleber zu einem solchen Zeitpunkt aufzunehmen, daß das SMD-Bauelement schließlich zuverlässig auf dem Substrat befestigt werden kann. Besonders günstig ist die Form der Kavität 3 dann, wenn ein Zweikomponentenkleber verwendet wird, wobei eine Kleberkomponente in der Kavität 3 untergebracht werden kann, so daß der Kleber dann insgesamt infolge der Kavität in ausreichender Menge in einem eigenen und separaten Raum untergebracht werden kann, um eine gute Klebewirkung zu erzielen, wobei durch den Fußpunkt des Gehäuses 1 am Rand der Kavität 3 ein geeigneter Abstand zwischen den Anschlußbeinchen 2 und dem Substrat (Platine) definiert wird, so daß eine optimale elektrische Kontaktierung des SMD-Bauelementst bei optimaler Klebe-Kraft des Klebers gleichzeitig erzielt werden kann.

Der Fußpunkt des Gehäuses 1 am Rand des Gehäuses 1 kann auch erzielt werden, wenn der Rand der Kavität 3 nicht in jedem seiner Punkte auf dem Substrat (Platine) aufliegt.

**Patentansprüche**

1. Bauelement für die Oberflächenmontage mit einem Gehäuse (1) von beliebigen Abmessungen und mit einer beliebigen Zahl von Anschlußbeinchen (2), mit einer Oberfläche des Gehäuses (1), die mittels eines Klebers auf einer Oberfläche eines anderen Körpers (4) fixiert werden soll, wobei die zu fixierende Oberfläche des Gehäuses (1) zur Verbesserung der Haftfestigkeit eine Struktur aufweist, die es ermöglicht, daß Teile dieser zu fixierenden Oberfläche auf der Oberfläche des anderen Körpers (4) einerseits aufliegen können, wobei diese Teile dieser Oberfläche eine einzige Kavität innerhalb dieser Teile dieser Oberfläche definieren, daß andererseits jedoch eine zur Fixierung ausreichende Klebermenge (3) zwischen der zu fixierenden Oberfläche des Bauelements und der Oberfläche des anderen Körpers (4) verbleibt und dass die Anschlussbeinchen nicht mit Kleber bedeckt werden.

2. Bauelement nach Anspruch 1, dadurch gekennzeichnet, daß die zu fixierende Oberfläche des Gehäuses (1) mit einer Klebmasse (3) versehen ist.

3. Bauelement nach Anspruch 2, gekennzeichnet durch eine Gurtung dieses Bauelements.

4. Bauelement nach Anspruch 2 oder 3, gekennzeichnet durch eine Klebefolie als Kleber.

5. Bauelement nach einem der Ansprüche 2 bis 4, gekennzeichnet durch Klebstoff als Kleber.

6. Verfahren zur Befestigung eines Bauelements für die Oberflächenmontage mit einem Gehäuse (1) von beliebigen Abmessungen und mit einer beliebigen Zahl von Anschlußbeinchen, mit einer zu fixierenden Oberfläche, die mittels eines Klebers auf einer Oberfläche eines anderen Körpers (4) fixiert wird, wobei die zu fixierende Oberfläche des Gehäuses (1) zur Verbesserung der Haftfestigkeit mit einer einzigen Kavität versehen wird, so daß Teile der zu fixierenden Oberfläche des Bauelements auf der Oberfläche des anderen Körpers (4) einerseits aufliegen können, andererseits jedoch eine zur Fixierung ausreichende Klebermenge (3) zwischen der zu fixierenden Oberfläche des Bauelements und der Oberfläche des anderen Körpers (4) verbleibt, dass die Anschlussbeinchen nicht mit Kleber bedeckt werden, und wobei eine Klebermenge auf der Oberfläche des anderen Körpers (4) flächenförmig bereits vor der Oberflächenmontage des Bauelements aufgebracht wird.

7. Verfahren nach Anspruch 6, dadurch gekennzeichnet, daß eine Klebermenge durch Aufsprühen auf die Oberfläche des anderen Körpers (4) aufgebracht wird.

8. Verfahren nach Anspruch 6, dadurch gekennzeichnet, daß eine Klebermenge mittels eines Druckverfahrens auf die Oberfläche des anderen Körpers (4) aufgebracht wird.

9. Verfahren nach Anspruch 6, dadurch gekennzeichnet, daß eine Klebermenge in Form einer Klebefolie aufgebracht wird.

## Claims

1. Surface-mounted component having a housing (1) of any desired dimensions and having any desired number of connecting legs (2), having a surface, of the housing (1), which is intended to be fixed by means of a bonding agent to a surface of another body (4), the surface, to be fixed, of the housing (1) having, for the purpose of improving the adhesion, a structure which permits that parts of this surface to be fixed can on the one hand rest on the surface of the other body (4), these parts of this surface defining a single cavity within these parts of this surface, that on the other hand, however, an amount of bonding agent (3) sufficient for fixing remains between the surface, to be fixed, of the component and the surface of the other body (4), and that the connecting legs are not covered with bonding agent.

2. Component according to claim 1, characterized in that the surface, to be fixed, of the housing (1) is provided with an adhesive material (3).

3. Component according to claim 2, characterized by mounting of this component on a continuous tape.

4. Component according to claim 2 or 3, characterized by an adhesive film as bonding agent.

5. Component according to one of claims 2 to 4, characterized by adhesive as bonding agent.

6. Method for securing a surface-mounted component having a housing (1) of any desired dimensions and having any desired number of connecting legs, having a surface to be fixed which is fixed by means of a bonding agent to a surface of another body (4), the surface, to be fixed, of the housing (1) being provided, for the purpose of improving the adhesion, with a single cavity, so that parts of the surface, to be fixed, of the component can on the one hand rest on the surface of the other body (4), but on the other hand an amount of bonding agent (3) sufficient for fixing remains between the surface, to be fixed, of the component and the surface of the other body (4), and that the connecting legs are not covered with bonding agent, and an amount of bonding agent being already applied over all the surface of the other body (4) before the surface-mounting of the component.

7. Method according to claim 6, characterized in that an amount of bonding agent is applied by sputtering on to the surface of the other body (4).

8. Method according to claim 6, characterized in that an amount of bonding agent is applied by means of a printing method to the surface of the other body (4).

9. Method according to claim 6, characterized in that an amount of bonding agent is applied in the form of an adhesive film.

## Revendications

1. Composant destiné à être fixé sur une surface et comportant un boîtier (1) possédant des dimensions quelconques et un nombre quelconque de pattes de raccordement (2), et comportant une surface qui doit être fixée à l'aide d'une colle sur une surface d'un autre corps (4), la surface devant être fixée du boîtier (1) possédant, pour améliorer l'adhérence, une structure permettant d'une part d'appliquer des parties de cette surface devant être fixée sur la surface de l'autre corps (4), ces parties de cette surface définissant une seule cavité à l'intérieur d'elles-mêmes, alors que par ailleurs il subsiste une quantité de colle (3) suffisante pour la fixation, entre la surface devant être fixée du composant et la surface de l'autre corps (4), et que les pattes de raccordement ne sont pas recouvertes de colle.

2. Composant suivant la revendication 1, caractérisé par le fait que la surface devant être fixée du boîtier (1) comporte une masse de colle (3).

3. Composant suivant la revendication 1, caractérisé par un ceinturage de ce composant.

4. Composant suivant la revendication 2 ou 3, caractérisé par une couche adhésive à titre de colle.

5. Composant suivant l'une des revendications 2 à 4, caractérisé par un adhésif en tant que colle.

6. Procédé pour fixer un composant destiné à être installé sur une surface et comportant un boîtier (1) possédant des dimensions quelconques, un nombre quelconque de pattes de raccordement et une surface devant être fixée, que l'on fixe à l'aide d'une colle sur une surface d'un autre corps (4), et selon lequel, pour améliorer l'adhérence, on aménage une seule cavité dans la surface devant être fixée du boîtier (1) de sorte que d'une part des parties de la surface devant être fixée du composant peuvent s'appliquer sur la surface de l'autre corps (4), mais que d'autre part il subsiste une quantité de colle (3), suffisante pour la fixation, entre la surface devant être fixée du composant et la surface de l'autre corps (4), et selon lequel on ne recouvre pas de colle les pattes de raccordement, et on dépose une quantité de colle sur une certaine étendue de la surface de l'autre corps (4), déjà avant la fixation du composant sur une surface.

7. Procédé suivant la revendication 6, caractérisé par le fait qu'on dépose une quantité de colle par pulvérisation sur la surface de l'autre corps (4).

8. Procédé suivant la revendication 6, caractérisé par le fait qu'on dépose une quantité de colle à l'aide d'un procédé de refoulement sur la surface de l'autre corps (4).

9. Procédé suivant la revendication 6, caractérisé par le fait qu'on dépose une quantité de colle sous la forme d'une feuille adhésive.

# FIG 1

1

2

3

4

# FIG 2

1

2

3

4